# EUROPÄISCHE PATENTSCHRIFT

(11) **EP 0 886 991 B1**
(45) Veröffentlichungstag und Bekanntmachung des Hinweises auf die Patenterteilung: **27.10.2004**
(21) Anmeldenummer: 97943746.4
(22) Anmeldetag: 09.09.1997
(51) Int. Cl.: H05K 1/00

(54) **LEITERFOLIE ZUR LEITENDEN VERBINDUNG VON ELEKTRISCHEN UND/ODER ELEKTRONISCHEN BAUKOMPONENTEN**
CONDUCTING FOIL FOR CONDUCTIVELY CONNECTING ELECTRIC AND/OR ELECTRONIC COMPONENTS
FILM CONDUCTEUR POUR CONNECTER DE MANIERE CONDUCTIVE DES COMPOSANTS ELECTRIQUES ET/OU ELECTRONIQUES

(30) Priorität: 20.12.1996 DE 19653360
(43) Veröffentlichungstag der Anmeldung: 30.12.1998
(73) Patentinhaber: ROBERT BOSCH GMBH, 70442 Stuttgart (DE)
(72) Erfinder: MILLER, Bernhard, D-70439 Stuttgart (DE); ROETHER, Friedbert, D-74389 Cleebronn (DE); SCHNEIDER, Norbert, D-75233 Tiefenbronn (DE)
(86) Internationale Anmeldenummer: PCT/DE1997/001995
(87) Internationale Veröffentlichungsnummer: WO 1998/028956

(56) Entgegenhaltungen:
- EP-A- 0 635 995
- US-A- 5 495 076
- US-A- 5 585 157
- C. D. KEIRSTEAD: "Flexible printed circuits: a design primer" ASSEMBLY ENGINEERING, Bd. 31, Nr. 5, 1988, WHEATON, IL, US, Seiten 32-36, XP002051410
- PATENT ABSTRACTS OF JAPAN vol. 15, no. 290 (M-1139), 23.Juli 1991 & JP 03 104755 A (AISIN SEIKI CO), 1.Mai 1991,

## Beschreibung

### Stand der Technik

Es ist bereits bekannt Leiterfolien zur elektrischen Verbindung von elektrischen oder elektronischen Komponenten zu verwenden. Die Leiterfolien weisen eine mehrlagige Struktur auf, wobei auf eine nichtleitende Trägerfolie Leiterbahnstrukturen aufgebracht sind, die nach außen isoliert sind. Es ist zum beispiel bekannt, dünne Kupferleiterbahnen auf eine Trägerfolie aus Polyimid aufzubringen und mit einer weiteren Trägerfolie abzudecken. Die Leiterbahnen sind mit auf der Leiterfolie angeordneten Lötflächen zur Verlötung mit den elektrischen Anschlüssen der Baukomponenten leitend verbunden. Derartige Leiterfolien werden zum Beispiel in der Nähe von Kfz-Motoren oder Getriebeaggregaten eingesetzt. So ist zum Beispiel bekannt, im Gehäuse eines Kupplungsstellers eine Hybridschaltung zu integrieren, die über eine Leiterfolie mit verschiedenen Ventilen zur Druckluftregelung, sowie mit einem Wirbelstromsensor und einem Steckerteil zum Anschluß an externe Kabel verbunden ist. Die Hybridschaltung weist zu diesem Zweck eine Steckerleiste auf, deren Steckerstifte mit den als Lötaugen ausgestalteten Lötflächen der Leiterfolie verlötet werden. Die elastisch verformbaren Leiterfolien weisen zwar eine große Festigkeit gegenüber Vibrationsbelastungen auf, jedoch bewirken die in derartigen Aggregaten auftretenden extremsten Schüttelbelastungen mit Beschleunigen bis zu 50 g, daß die Lötfhächen der Leiterfolie extrem stark belastet werden. Vibrationsbelastungen, die über einen schwingenden Zuleitungsabschnitt der Leiterfolie auf die Steckerleiste übertragen werden, können zur Folge haben, daß die Lötstellen brechen oder einzelne Steckerstifte aus der Leiste gebrochen werden.

Aus der Veröffentlichung des Aufsatzes von C. D. Keirstead "Flexible printed circuits: a design primer" in der Zeitschrift "Assembly Engineering" , Seite 32 bis 36, vol. 31, no. 5. 1988, erschienen in Wheaton, IL, US ist eine Leiterfolie gemäß den Merkmalen des Oberbegriffs des Anspruchs 1 bekannt, siehe dort Seite 35, Figur 10. Es ist dabei vorgesehen, dass die Leiterfolie durch Befestigungsmittel über Verstärkungen fixiert wird, um so Schwingungen abzuleiten und von schwingungsempfindlichen Bauteilen fern zu halten.

### Vorteile der Erfindung

Die erfindungsgemäße Leiterfolie mit den Merkmalen des Anspruchs 1 hat demgegenüber den Vorteil, dass über den Versteifungsabschnitt eine Verbindungsstelle zu verbinden ist, die zur Erdung einer Baukomponente dient und somit nicht nur eine Fixierung der Leiterfolie möglich ist, sondern auch gleichzeitig eine Erdung möglich ist, ohne weitere aufwändige Maßnahmen, wie z. B. längere Leiter, erforderlich sind. Darüber hinaus ist eine verringerte Anzahl an Verbindungsstellen zu erwarten. Fehlermöglichkeiten können so verringert und die Zuverlässigkeit gesteigert werden.

Weiterhin ist vorteilhaft, in den Versteifungsabschnitt eine Verbindungsstelle zu integrieren, welche von den Lötstellen des Zuleitungsabschnitts räumlich getrennt ist und an ein Verbindungsmittel angeschlossen werden kann. Die Verbindungsstelle kann zum Beispiel mit einer Schraube oder einem entsprechenden Hilfsmittels an einem Gehäuseteil befestigt werden. Bei Vibrationsbelastungen werden dann die an dem Versteifungsabschnitt angreifenden Kräfte des Leiterfolienzuleitungsabschnitts auf die mit der Verbindungsstelle verbundene Schraube übertragen.

Vorteilhaft kann die Verstärkungsschicht eine zusätzliche Polyimidschicht und/oder eine auf der Leiterfolie aufgebrachte Metallschicht, z.B. eine verzinnte Kupferschicht, sein. Diese Schichten können vorteilhaft einen Scheuerschutz der Leiterfolie an solchen Stellen bewirken, an denen die Leiterfolie Gehäuseteile berührt. Die verzinnte Kupferschicht kann bei der Herstellung der Leiterfolie zusammen mit den zum Anschluß der Baukomponenten vorgesehenen Lötflächen auf einfache Weise hergestellt werden.

Besonders vorteilhaft ist es, die Verbindungsstelle zur Erdung der mit den Lötstellen verbundenen Baukomponente vorzusehen. Zu diesem Zweck ist eine weiterer elastisch verformbarer Folienabschnitt vorgesehen, der eine einzelne Erdungsleiterbahn beinhaltet und eine mit einem Erdungsstift der Baukomponente verlötete Lötfläche des Zuleitungsabschnitts mit der Verbindungsstelle verbindet. Bei einer im Vibrationsfall auftretenden Relativbewegung zwischen der an einem Gehäuseteil befestigten Verbindungstelle und den Lötstellen der Baukomponente wird durch den elastischen Folienabschitt keine Kraft auf die empfindlichen Lötstellen übertragen.

Vorteilhaft ist weiterhin, den dem beweglichen Teil des Zuleitungsabschnitts zugewandten Rand der Verstärkungsschicht mit einer gezackten Kontur auszugestalten, um einen gleitenden Übergang vom Verstärkungsbereich in den elastisch verformbaren Bereich des Zuleitungsabschnitts zu erreichen und einen Bruch der Leiterbahnen an dieser Stelle zu vermeiden.

### Zeichnung

Ein Ausführungsbeispiel der Erfindung ist in der Zeichnung dargestellt und wird in der nachfolgenden Beschreibung näher erläutert. Es zeigt
Fig. 1a schematisch die innere Lage der Leiterfolie mit den Leiterbahnstrukturen,
Fig. 1b eine Draufsicht auf die Leiterfolie,
Fig. 1c eine Ansicht der Leiterfolie von unten,
Fig. 2 einen schematischen Querschnitt durch einen Teil der Leiterfolie.

### Beschreibung eines Ausführungsbeispiels

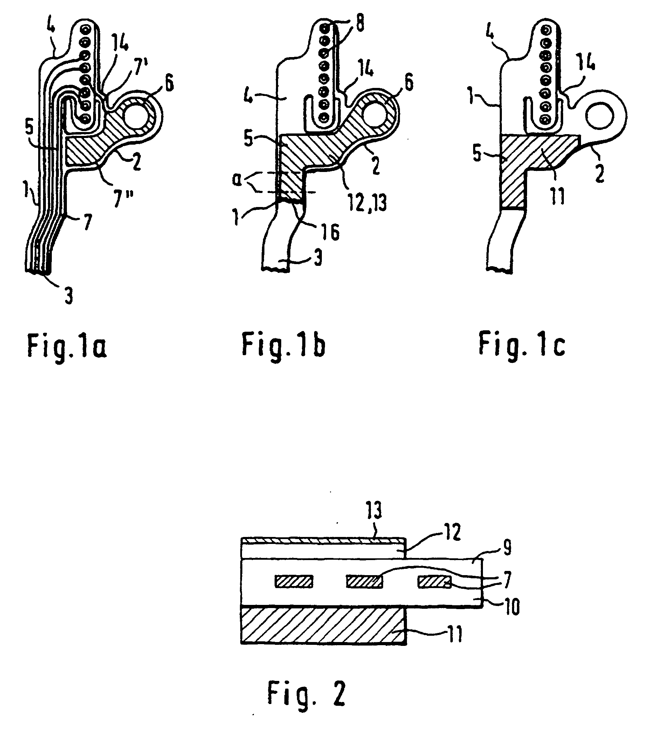

In Fig. 1 ist ein Ausschnitt aus einer Leiterfolie mit einem Zuleitungsabschnitt 1 dargestellt. Die Leiterfolie weist, wie in Fig. 1a dargestellt, auf einer mittleren Lage dünne Kupferleiterbahnen 7,7' und 7'' auf, die auf der Ober- und Unterseite von elastisch verformbaren Polyimidschichten 9,10 bedeckt sind. Der Schichtaufbau der Leiterfolie ist schematisch in Fig. 2 dargestellt. Die Leiterbahnen 7 des Zuleitungsabschnitts 1 sind mit Lötflächen 8 verbunden, die zur Verlötung mit den Steckerstiften eines nicht dargestellten elektronischen Schaltungsträgers vorgesehen sind. Die Lötflächen 8 sind in Form von Lötaugen ausgestaltet. Die Leiterbahnen können zum Beispiel über metallisierte Durchführungslöcher in bekannter Weise mit den Lötflächen 8 auf der Oberseite (Fig. 1b) verbunden sein. Beim Anschluß der Leiterfolie an einen Schaltungsträger, z.B. eine Hybridschaltung, werden die Steckerstifte der Hybridschaltung durch die Durchführungslöcher hindurchgeführt und mit den Lötaugen verlötet. Bei Schüttelbelastungen der Anordnung schwingt bzw. vibriert das mit den übrigen Zuleitungsabschnitten der Leiterfolie verbundene, frei bewegliche und elastisch verformbare Ende 3 des Zuleitungsabschnitts 1. Wie in Fig. 1 gezeigt ist von dem Zuleitungsabschnitt ein Versteifungsabschnitt 2 abgezweigt. Der Versteifungsabschnitt 2 weist eine großflächige Leiterbahn 7'' auf der inneren Lage der Leiterfolie auf (Fig. 1a). An die großflächige Leiterbahn 7'' ist eine weitere Leiterbahn 7' angeschlossen, die über einen schmalen elastisch verformbaren Folienabschnitt 14 mit einer der Lötflächen 8 auf dem Zuleitungsabschnitt 1 verbunden ist. Wie in Fig. 1b und Fig. 2 dargestellt ist, ist auf der Oberseite der Leiterfolie eine Kupferschicht 12 vorgesehen, die von einer Zinnschicht 13 bedeckt ist. Diese Metallschichten bilden eine Verstärkungsschicht, welche die Steifigkeit der Leiterfolie im Bereich des Versteifungssabschnitts 2 erhöht. Die Metallschichten 12,13 erstrecken sich über den gesamten Versteifungsabschnitt 2 und über den Teil des Zuleitungsabschnitt 1, welcher den Anbindungsbereich 5 des Versteifungsabschnitt 2 bildet. Auf der Rückseite der Leiterfolie ist, wie in Fig. 1c und Fig. 2 dargestellt, auf den Versteifungsbereich 5 eine zusätzliche Polyimidschicht 11 aufgebracht, die diesen zumindest teilweise überdeckt. Die Polyimidschicht erstreckt sich auch über den Anbindungsbereich 5 von Zuleitungsabschnitt 1 und Versteifungsabschnitt 2 und weist eine größere Dicke auf als die Polyimidschicht 10. In dem Versteifungsabschnitt 2 ist eine als kreirunde Öffnung ausgebildete Verbindungsstelle 6 angeordnet. Die Innenwandung der Öffnung ist über eine Durchmetallisierung mit der Leiterbahn 7' und der Leiterbahn 7'' verbunden. Der Versteifungsabschnitt 2 kann mit einer durch diese Öffnung durchgeführten Schraube beispielsweise mit einem Gehäuseteil verschraubt werden. Über die Leiterbahn 7' wird dann gleichzeitig eine Erdung der an diese Leiterbahn angeschlossenen Lötfläche 8 und des damit verbundenen Stekkerstiftes der Hybridschaltung erreicht. Bei Vibrationsoder Schüttelbelastungen der Anordnung, wirken nun beschleunigende Kraft über das frei bewegliche Ende 3 des Zuleitungsabschnitts 1 auf die Verstärkungsschichten 11,12,13 ein und werden von diesen zur Verbindungsstelle 6 abgeleitet, so daß eine Zugentlastung der Lötflächen 8 erreicht wird und keine großen Belastungen auf diese übertragen werden. Gleichzeitig erlaubt der elastische Folienabschnitt 14 mit der Erdungsleiterbahn eine Relativbewegung zwischen der Verbindungsstelle 6 des Versteifungsabschnitts und den Lötflächen 8, ohne daß Kräfte auf die Stiftleiste des Hybrids abgeleitet werden. Der dem Ende 3 des Zuleitungsabschnitts 1 zugewandte Rand 16 der verzinnten Kupferschicht 12,13 ist mit einem gezackten Rand versehen, um einen Bruch der Leiterbahnen 7 im Übergangsbereich zwischen flexibler Leiterfolie und versteifter Leiterfolie zu verhindern. In dem hier gezeigten Ausführungsbeispiel berührt die Leiterfolie im Bereich a eine metallische Gehäusewand. Die Polyimidschicht 11 und die Metallschichten 12,13 bewirken in diesem Bereich vorteilhaft einen Scheuerschutz der Leiterfolie.

## Patentansprüche

1. Leiterfolie zur leitenden Verbindung von elektrischen und/oder elektronischen Baukomponenten mit auf einer elastisch verformbaren, nichtleitenden Trägerfolie aufgebrachten, nach außen isolierten Leiterbahnen (7), sowie mit den Leiterbahnen (7) verbundenen Lötflächen (8), zur Verlötung mit elektrischen Anschlüssen der Baukomponenten, wobei die Leiterfolie Zuleitungsabschnitte (1) aufweist, durch welche die Leiterbahnen (7) zu den Lötflächen (8) hingeführt sind, wobei die Leiterfolie zumindest einen von wenigstens einem Zuleitungsabschnitt (1) abzweigenden Versteifungsabschnitt (2) aufweist, der bei Schüttelbelastungen eine Kraftableitung der durch das nicht mit den Lötflächen (8) verbundene, bewegliche Ende (3) dieses Zuleitungsabschnitts übertragenen Vibrationen auf den Versteifungsabschnitt (2) bewirkt, **dadurch gekennzeichnet, daß** der Versteifungsabschnitt (2) mit einer zur Erdung vorgesehenen Verbindungsstelle (6) außerhalb der mit den Lötstellen (8) des Zuleitungsabschnitts (1) verlöteten Baukomponente verbindbar ist.

2. Leiterfolie nach Anspruch 1, **dadurch gekennzeichnet, daß** wenigstens eine sich zumindest teilweise über den Versteifungsabschnitt (2) und über den Zuleitungsabschnitt (1) in deren gemeinsamen Anbindungsbereich (5) erstreckende Verstärkungsschicht (11,12,13) vorgesehen ist.

3. Leiterfolie nach Anspruch 2 , **dadurch gekennzeichnet, daß** als Verstärkungsschicht eine Metallschicht (12,13) und/oder eine nichtleitende Kunststoffschicht (11) auf die Leiterfolie aufgebracht ist.

4. Leiterfolie nach Anspruch 3, **dadurch gekennzeichnet, daß** die Metallschicht aus einer mit Zinn (13) überzogenen Kupferschicht (12) besteht.

5. Leiterfolie nach Anspruch 3, **dadurch gekennzeichnet, daß** die Kunststoffschicht (11) aus Polyimid besteht.

6. Leiterfolie nach Anspruch 1, **dadurch gekennzeichnet, daß** wenigstens eine Lötfläche (8) des Zuleitungsabschnitts (1) durch einen mit dem Zuleitungsabschnitt verbundenen, eine einzelne Leiterbahn (7') beinhaltenden Folienabschnitt (14) mit der Verbindungsstelle (6) verbunden ist.

7. Leiterfolie nach Anspruch 6, **dadurch gekennzeichnet, daß** die wenigstens eine Lötfläche (8) zur Verbindung mit dem Erdungsanschluß einer Baukomponente und die einzelne Leiterbahn (7') als Erdungsleiterbahn vorgesehen ist.

8. Leiterfolie nach Anspruch 2, **dadurch gekennzeichnet, daß** der dem nicht mit den Lötflächen (8) verbundenen Ende (3) des Zuleitungsabschnitt (1) der Leiterfolie zugewandte Rand (16) der Verstärkungsschicht eine gezackte Kontur aufweist.

## Claims

1. Foil conductor for conductively connecting electrical and/or electronic components, with conductor tracks (7) applied to an elastically deformable, non-conducting carrier foil and insulated with respect to the outside, and also with soldering areas (8) connected to the conductor tracks (7), for soldering to electrical terminals of the components, the conductor foil having feed line segments (1), by which the conductor tracks (7) are led to the soldering areas (8), the conductor foil having at least one reinforcing segment (2), which branches away from at least one feed line segment (1) and under vibrational loads causes the force of the vibrations transferred through the movable end (3) of this feed line segment that is not connected to the soldering areas (8) to be diverted to the reinforcing segment (2) , **characterized in that** the reinforcing segment (2) can be connected to a connecting point (6), provided for earthing, outside the component soldered to the soldering points (8) of the feed line segment (1).

2. Foil conductor according to Claim 1, **characterized in that** at least one reinforcing layer (11, 12, 13) is provided, extending at least partly over the reinforcing segment (2) and over the feed line segment (1) in their common bonding region (5).

3. Foil conductor according to Claim 2, **characterized in that** a metal layer (12, 13) and/or a layer of non-conducting plastic (11) is applied to the foil conductor as a reinforcing layer.

4. Foil conductor according to Claim 3, **characterized in that** the metal layer comprises a copper layer (12) coated with tin (13).

5. Foil conductor according to Claim 3, **characterized in that** the layer of plastic (11) consists of polyimide.

6. Foil conductor according to Claim 1, **characterized in that** at least one soldering area (8) of the feed line segment (1) is connected to the connecting point (6) by a foil segment (14) which is connected to the feed line segment and comprises a single conductor track (7').

7. Foil conductor according to Claim 6, **characterized in that** the at least one soldering area (8) is provided for the connection to the earthing terminal of a component and the individual conductor track (7') is provided as the earthing conductor track.

8. Foil conductor according to Claim 2, **characterized in that** the edge (16) of the reinforcing layer facing the end (3) of the feed line segment (1) of the conductor foil that is not connected to the soldering areas (8) has a serrated contour.

## Revendications

1. Film conducteur pour connecter de manière conductrice des composants électriques et/ou électroniques à des pistes conductrices (7) isolées par rapport à l'extérieur appliquées sur une feuille de support non conductrice élastiquement déformable, ainsi qu'à des surfaces de brasage (8) reliées aux pistes conductrices (7) pour le brasage des composants avec des contacts électriques, le film conducteur présentant des segments d'amenée (1) par lesquels les pistes conductrices (7) sont amenées vers les surfaces de brasage (8), le film conducteur présentant au moins un segment de raidissement (2) dérivé d'au moins un segment d'amenée (1), qui en cas de sollicitations par secousses provoque une dérivation de force des vibrations transmises par l'extrémité (3) mobile de ce segment d'amenée qui n'est pas reliée aux surfaces de brasage (8) vers le segment de raidissement (2) ,
**caractérisé en ce que**
le segment de raidissement (2) peut être connecté à un point de liaison (6) prévu pour la mise à la terre situé à l'extérieur du composant brasé aux points de brasage (8) du segment d'amenée (1).

2. Film conducteur selon la revendication 1,
**caractérisé en ce qu'**
au moins une couche de renforcement (11, 12, 13) s'étend du moins partiellement sur le segment de raidissement (2) et sur le segment d'amenée (1) au niveau de leur zone de jonction (5) commune.

3. Film conducteur selon la revendication 2,
**caractérisé en ce qu'**
en tant que couche de renforcement une couche métallique (12, 13) et/ou une couche en matière plastique (11) non conductrice est appliquée sur le film conducteur.

4. Film conducteur selon la revendication 3,
**caractérisé en ce que**
la couche métallique est une couche en cuivre (12) revêtue d'étain (13).

5. Film conducteur selon la revendication 3,
**caractérisé en ce que**
la couche en matière plastique (11) est en polyimide.

6. Film conducteur selon la revendication 1,
**caractérisé en ce qu'**
au moins une surface de brasage (8) du segment d'amenée (1) est connectée au point de liaison (6) par un segment de film (14) relié au segment d'amenée et contenant une piste conductrice (7') unique.

7. Film conducteur selon la revendication 6,
**caractérisé en ce que**
l'au moins une surface de brasage (8) est prévue pour être connectée au contact de terre d'un composant et l'unique piste conductrice (7') est prévue comme piste conductrice de mise à la terre.

8. Film conducteur selon la revendication 2,
**caractérisé en ce que**
le bord (16) de la couche de renforcement situé en regard de l'extrémité (3) du segment d'amenée (1) du film conducteur qui n'est pas reliée aux surfaces de brasage (8) présente un contour dentelé.
